# EUROPÄISCHE PATENTANMELDUNG

(11) **EP 1 132 964 A2**
(43) Veröffentlichungstag der Anmeldung: **12.09.2001**
(21) Anmeldenummer: 01104998.8
(22) Anmeldetag: 01.03.2001
(51) Int. Cl.: H01L 25/07

(54) **Anordnung zur Verschaltung von Leistungshalbleiterchips in Modulen**

(30) Priorität: 10.03.2000 DE 10011633
(71) Anmelder: eupec Europäische Gesellschaft für Leistungshalbleiter mbH & Co. KG, 59581 Warstein (DE)
(72) Erfinder: Loddenkoetter, Manfred, 49477 Ibbenbüren (DE)
(74) Vertreter: MÜLLER & HOFFMANN Patentanwälte

(57) **Zusammenfassung**

Die Erfindung betrifft eine Anordnung zur Verschaltung von Leistungshalbleiterchips in Modulen, bei der die Leistungshalbleiterchips (1, 2) schachbrettmusterartig angeordnet sind und jeweils ein Funktionstyp der Leistungshalbleiterchips (1, 2) einer "Farbe" der Felder des Schachbrettmusters zugeordnet ist.

## Beschreibung

Die vorliegende Erfindung betrifft eine Anordnung zur Verschaltung von Leistungshalbleiterchips in Modulen, bei der die Leistungshalbleiterchips wenigstens zwei verschiedenen Funktionstypen zugeordnet und jeweils über keramische Substrate auf eine gemeinsame Bodenplatte aufgebracht sind.

In Leistungshalbleitermodulen sind bekanntlich elektronische Bauteile, wie insbesondere IGBT-Chips und Dioden-Chips miteinander verschaltet (IGBT = Bipolartransistor mit isoliertem Gate). Außer IGBT-Chips und Dioden-Chips können in solchen Leistungshalbleitermodulen auch andere elektronische Bauteile eingesetzt werden. Beispiele hierfür sind Leistungstransistoren, Thyristoren und so weiter.

Die Leistungshalbleiterchips sind in solchen Leistungshalbleitermodulen auf keramischen Substraten, wie beispielsweise DCB aufgelötet (DCB = "Sandwichsubstrat" Kupfer-Keramik-Kupfer). Die keramischen Substrate ihrerseits sind vorzugsweise mit einer Bodenplatte verlötet.

Bei einer derartigen Anordnung übernimmt das keramische Substrat, also insbesondere DCB, die Funktion einer elektrischen Isolation und einer thermischen Leitung der im Leistungshalbleiterchip entstehenden Wärme. Außerdem beinhaltet das keramische Substrat Strukturen, die in Verbindung mit gebondeten Drähten die elektrische Funktion des Leistungshalbleiterchips verwirklichen.

Die Bodenplatte dient mechanisch als Träger sowie thermisch als Wärmekapazität und Wärmeleiter zu einem gegebenenfalls zusätzlich vorgesehenen Kühlkörper, auf welchen der Leistungshalbleitermodul geschraubt ist.

In einem solchen Leistungshalbleitermodul können, wenn hohe Leistungen zu verarbeiten sind, zahlreiche Leistungshalbleiterchips intern parallel zueinander geschaltet werden. Speziell bei einer solchen Parallelschaltung treten aber verschiedene Probleme auf, die im folgenden näher angegeben werden sollen:

Räumlich eng nebeneinanderliegende bzw. benachbarte Leistungshalbleiterchips beeinflussen sich thermisch gegenseitig, was eine unkontrollierte Erwärmung des Moduls nach sich zieht und eine Abfuhr von Wärme bzw. Entwärmung des Moduls schwierig macht.

Lokale Wärmespitzen, die speziell bei unsymmetrischen Anordnungen der einzelnen Leistungshalbleiterchips auftreten, können statische und dynamische Fehlaufteilungen von Strömen im Modul sowie Schwingungserscheinungen nach sich ziehen.

Schließlich werfen Funktionserweiterungen eines Moduls Probleme auf, wenn beispielsweise eine Grundfunktion, die von mehreren einzelnen Leistungshalbleiterchips ausgeübt wird, geändert werden soll; das heißt, die Flexibilität des Moduls ist eingeschränkt.

Um die oben genannten Probleme zu vermeiden bzw. zu umgehen, wird bisher daran gedacht, die einzelnen Leistungshalbleiterchips direkt nebeneinander vorzusehen und dabei aber thermisch geringer zu beanspruchen, was aber aufwendige Kühlkonzepte notwendig macht. Eine andere Möglichkeit besteht darin, in einem Modul nur eine geringere Anzahl von Leistungshalbleiterchips zu integrieren, also einen größeren Platzbedarf in Kauf zu nehmen. Weiterhin können Fehlaufteilungen von Strömen oder Schwingungserscheinungen als unvermeidbar akzeptiert werden. Schließlich sind Funktionserweiterungen bzw. Änderungen einer Grundfunktion möglich, wenn das Layout des Moduls grundsätzlich entsprechend verändert wird, was praktisch einer Neukonstruktion des Moduls gleich kommt.

Es gibt also bisher noch keine befriedigende Lösung der oben aufgezeigten Probleme.

Es ist daher Aufgabe der vorliegenden Erfindung, eine Anordnung zur Verschaltung von Leistungshalbleiterchips in Modulen anzugeben, bei der thermische Beeinflussungen der Leistungshalbleiterchips untereinander weitgehend ausgeschlossen sind, so daß auch keine statischen und dynamischen Fehlaufteilungen von Strömen auftreten, und bei der zusätzlich Funktionserweiterungen ohne grundsätzliche Änderung des Layouts des Moduls möglich sind.

Diese Aufgabe wird bei einer Anordnung der eingangs genannten Art erfindungsgemäß dadurch gelöst, daß die Leistungshalbleiterchips schachbrettmusterartig angeordnet sind und möglichst gleiche Funktionstypen Felder der gleichen Farbe des Schachbrettmusters besetzen.

Bei der erfindungsgemäßen Anordnung sind also beispielsweise IGBT-Leistungshalbleiterchips und Dioden-Leistungshalbleiterchips schachbrettmusterartig auf den einzelnen Substraten sowie insgesamt auf der Bodenplatte in dem Modul vorgesehen. Leistungshalbleiterchips der gleichen Funktionstypen belegen dabei jeweils Felder der gleichen Farbe des Schachbrettmusters. Mit anderen Worten, IGBT-Leistungshalbleiterchips werden beispielsweise auf "schwarzen" Feldern vorgesehen, während Dioden-Leistungshalbleiterchips den "weißen" Feldern zugewiesen sind.

Durch diese Maßnahme überlappen sich die Wärmespreizungszonen der einzelnen Leistungshalbleiterchips nur minimal. Außerdem wird in vorteilhafter Weise ausgenutzt, daß Leistungshalbleiterchips mit unterschiedlicher Funktion, also beispielsweise IGBT-Leistungshalbleiterchips und Dioden-Leistungshalbleiterchips, in den unterschiedlichen Betriebszuständen des Moduls nicht zeitgleich ihre stärkste Erwärmung erfahren, so daß selbst eine gegebenenfalls auftretende Überlappung der Wärmespreizungszonen ohne negative Auswirkungen bleibt.

Die Realisierung einer elektrischen Grundfunktion als Halbbrücke auf nur einem Substrat, insbesondere DCB, führt zu einer räumlichen Trennung parallelgeschalteter Leistungshalbleiterchips auf benachbarten Substraten, so daß auch hier keine Überlappungen von Wärmespreizzonen zu erwarten sind.

Durch die bereits erwähnte Realisierung einer elektrischen Grundfunktion als Halbbrücke auf einem Substrat wird durch entsprechende Strukturierung eines Bussystems eine symmetrische Parallelschaltung der Grundfunktionen durch Bonddrähte möglich. Diese symmetrische Anordnung, deren Symmetrie sich auch auf weitere Leitungen, wie insbesondere Steuerleitungen bezieht, wird im Modul mehrfach dupliziert angewendet.

Da schließlich die Grundfunktion auf einem Substrat realisiert ist, kann ein parallel geschaltetes Substrat durch eine andere Funktion ersetzt werden, ohne das Grundkonzept des Moduls neu aufzubauen und zu verändern. Diese Flexibilität wird durch die bereits erwähnte Symmetrie des Bussystems gefördert.

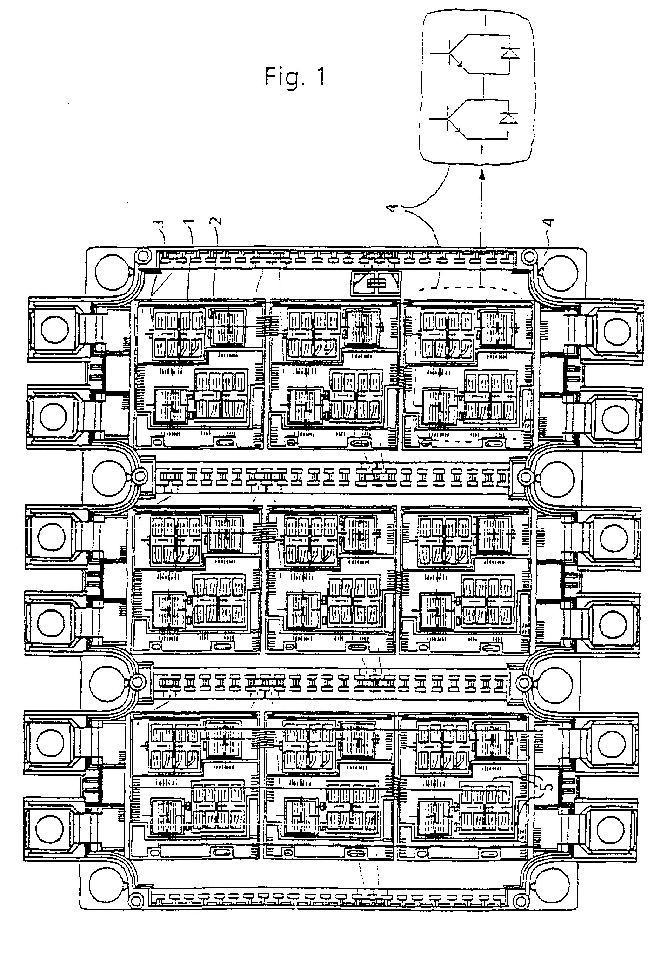

Nachfolgend wird die Erfindung anhand der Zeichnung näher erläutert, in deren einziger Figur eine schematische Draufsicht auf einen Modul gezeigt ist.

In diesem Modul sind einzelne Leistungshalbleiterchips in der Form von IGBT-Chips 1 und Dioden-Chips 2 über Substrate 3 auf einer Grundplatte 4 aufgebracht und dabei schachbrettmusterartig angeordnet. Für die Substrate 3 wird dabei in bevorzugter Weise DCB verwendet.

Auf den Substraten 3 sind elektrische Grundfunktionen als Halbbrücken 4 realisiert und mittels eines Bussystems 5 und entsprechenden Bonddrähten parallel zueinander geschaltet. Zur Vereinfachung der Darstellung sind jeweils nur ein Bussystem 5 und eine Halbbrücke 4 besonders herausgestellt.

Durch die schachbrettmusterartige Anordnung der einzelnen Leistungshalbleiterchips wird erreicht, daß Überlappungen von Wärmespreizungszonen nur minimal sind. Außerdem wird in vorteilhafter Weise ausgenutzt, daß Leistungshalbleiterchips mit unterschiedlicher Funktion, also die IGBT-Chips 1 und die Dioden-Chips 2 in den unterschiedlichen Betriebszuständen des Moduls nicht zeitgleich ihre stärkste Erwärmung erfahren, so daß die zeitverschobene Überlappung der Wärmespreizungszonen ohne negative Auswirkungen bleibt.

Wesentlich an der vorliegenden Erfindung ist also die schachbrettmusterartige Anordnung von beispielsweise IGBT-Chips und Dioden-Chips in einem Modul, wobei funktionsgleiche Chips jeweils Felder der gleichen Farbe belegen. Bei einer derartigen Anordnung der verschiedenen Chips in einem Schachbrettmuster kann die Busstruktur ohne weiteres linear entlang der einzelnen Chips geführt werden. Elektrische Grundfunktionen lassen sich ohne weiteres auf einzelnen Substraten realisieren, wodurch eine Erweiterung durch identische Substrate möglich ist, um durch Parallelschaltung eine Leistungssteigerung zu erzielen. Ebenso kann eine Erweiterung durch abweichende Substrate vorgenommen werden, um zu einer Veränderung der Funktion des Moduls insgesamt zu gelangen.

So können beispielsweise einzelne Substrate durch Strom-Meßwiderstände ersetzt werden. Hiermit sind Zusatzfunktionen, also Strommessungen in beispielsweise linear geführten Phasenleitungen möglich. Ebenso können auch beispielsweise Gleichrichtereingangsbrücken anstelle einzelner Substrate in den Modul eingebaut werden.

## Patentansprüche

1. Anordnung zur Verschaltung von Leistungshalbleiterchips (1, 2) in Modulen, bei der die Leistungshalbleiterchips (1, 2) wenigstens zwei verschiedenen Funktionstypen zugeordnet und auf eine gemeinsame Bodenplatte (4) aufgebracht sind,
**dadurch gekennzeichnet**, daß
- die Leistungshalbleiterchips (1, 2) schachbrettmusterartig angeordnet sind und möglichst gleiche Funktionstypen Felder der gleichen Farbe des Schachbrettmusters besetzen,
- die Leistungshalbleiterchips (1, 2) jeweils über keramische Substrate (3) aus DCB auf der gemeinsamen Bodenplatte (4) aufgebracht sind, und
- in dem Schachbrettmuster ein Bussystem symmetrisch angeordnet ist.

2. Anordnung nach Anspruch 1,
**dadurch gekennzeichnet**, daß
die Funktionstypen durch IGBT's und Leistungsdioden gegeben sind.

3. Anordnung nach Anspruch 1 oder 2,
**dadurch gekennzeichnet**, daß
Grundfunktionen des Moduls auf jeweils einem der Substrate (3) realisiert sind.
